# EUROPEAN PATENT APPLICATION

(11) **EP 4 818 712 A1**
(43) Date of publication of application: **07.10.2026**
(21) Application number: 26160106.6
(22) Date of filing: 23.02.2026
(51) Int. Cl.: G01R 31/28

(54) **SIGNAL GENERATOR SYSTEM**

(30) Priority: 02.04.2025 US 202519098248
(71) Applicant: Rohde & Schwarz GmbH & Co. KG, 81671 München (DE)
(72) Inventor: Benneckenstein, Tim, 81671 München (DE); Scholl, Simon, 81671 München (DE); Vielhuber, Robert, 81671 München (DE); Falk, Nico, 81671 München (DE)
(74) Representative: Prinz & Partner mbB

(57) **Abstract**

A signal generator system (10) for generating a radio frequency signal is described. The signal generator system (10) comprises at least one data input, at least one control input, and a waveform processing circuit. The at least one data input is configured to receive at least one waveform data stream, the at least one waveform data stream comprising information on a waveform to be generated. The at least one control input is configured to receive at least one control command signal, the control command signal comprising control information for modifying the data stream. The at least one waveform processing circuit is configured to modify the at least one waveform data stream based on the control command signal, thereby obtaining at least one modified waveform data stream.

## Description

The present invention generally relates to a signal generator system for generating a radio frequency, RF, signal.

The generation and manipulation of radio frequency (RF) signals plays a critical role in various applications such as radar systems, direction finding systems, and communication systems.

For performing tests on such systems, accurately emulating the environmental conditions, as well as positions and/or movements of signal sources is essential for effective testing and validation. Existing solutions often involve static recordings or require significant post-processing to apply necessary modifications. These solutions may be time-consuming and computationally expensive, which may make existing solutions inadequate for real-time applications.

Thus, the object of the present invention is to provide a signal generator system that provides improved possibilities to alter the RF signal for testing purposes.

According to the present invention, the problem is solved by a radio frequency, RF, signal. The signal generator system comprises at least one data input, at least one control input, and a waveform processing circuit. The data input is configured to receive at least one waveform data stream, the at least one waveform data stream comprising information on a waveform to be generated. The at least one control input is configured to receive at least one control command signal, the control command signal comprising control information for modifying the data stream. The at least one waveform processing circuit is configured to modify the at least one waveform data stream based on the control command signal, thereby obtaining at least one modified waveform data stream.

Therein and in the following, the term "circuit" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Accordingly, the term "circuit" can describe a module with suitable hardware, suitable software, or a combination of hardware and software that is configured to have the described functionality.

The signal generator system according to the present invention is based on the idea to provide dynamic real-time adjustments of high-volume data streams.

While previously known approaches may rely on offline methodologies to provide specific measurement scenarios, the signal generator system according to the present invention enables continuous waveform modifications on-the-fly, thereby reducing the latency and complexity typically associated with emulating measurement scenarios.

By performing real-time data manipulation of the waveform data stream, the signal generator system according to the present invention enables complex testing scenarios for a plurality of different devices under test, which may not be achievable via previously known methods.

In fact, by dynamically adjusting parameters such as amplitude, frequency, and phase without halting the data stream, a multitude of application possibilities are achieved. For example, the signal generator system according to the present invention supports direction finding tests, phased-array assessments, and various hardware-in-the-loop evaluations that require synchronized, high-volume signal recordings.

As a result, the signal generator system according to the present invention not only streamlines experimentation, testing, and validation procedures, but also ensures higher fidelity of the measurements, thereby delivering more reliable results than what is conventionally attainable.

According to an aspect of the present invention, the waveform data stream is an IQ-data stream. Accordingly, the waveform data stream comprises in-phase (I) data and quadrature (Q) data relating to the waveform to be generated. The use of an IQ data stream in the signal generator system enables more precise control over phase and amplitude, thereby improving signal quality.

In an exemplary embodiment of the present invention, the signal generator system comprises at least one RF frontend, wherein the at least one RF frontend is configured generate at least one RF transmission signal. In fact, the at least one RF frontend may be configured to up-convert the frequency of the at least one modified waveform data stream to a predefined frequency that is appropriate for performing a corresponding measurement on a device under test, thereby obtaining the at least one RF transmission signal.

In fact, the at least one RF frontend may be configured to up-convert the frequency of the at least one modified waveform data stream by mixing the at least one RF transmission signal with a local oscillator signal having a predefined frequency.

According to another aspect of the present invention, the signal generator system further comprises an RF output interface, wherein the RF output interface is connectable to at least one RF antenna and/or to a device under test.

Accordingly, the at least one RF transmission signal may be transmitted over the air via the at least one RF antenna, e.g. to the device under test, such that the device under test can be tested over the air.

The at least one RF antenna may comprise a single RF antenna, a plurality of RF antennas, and/or an RF antenna array.

Alternatively, the device under test can be connected directly to the RF output interface, such that the at least one RF transmission signal may be transmitted to the device under test via a wire-based connection, thereby enabling hardware-in-the-loop (HIL) testing of the device under test.

For example, the at least one RF transmission signal may correspond to an emulated signal that would be received by at least one receiver antenna connected to the device under test. This enables, for example, to test an analysis circuit of the device under test such as a direction finding system without the corresponding receiver antennas being necessary.

The signal generator system may further comprise at least one sample memory being connected to the at least one data input, wherein the at least one sample memory is configured to store the waveform data stream received via the data input. The sample memory allows for (temporary) local storage of the incoming waveform data stream, thereby enhancing the resilience to latencies in the waveform data stream. In other words, the at least one sample memory may be configured as a buffer memory.

It also conceivable that different waveform data streams may be stored in the at least one sample memory, which allows for a seamless switching between the different waveform data streams for performing tests associated with different testing scenarios.

The at least one sample memory may be a non-transient memory.

As another example, the at least one sample memory may be a temporary memory such as a random access memory.

In a further exemplary embodiment of the present invention, the signal generator system is configured to generate at least two different modified waveform data streams. As will be described in more detail below, this drastically increases the number of testing scenarios that can be emulated via the signal generator system according to the present invention.

For example, the at least two different modified waveform data streams may correspond to different aspects of a testing scenario, such as different signal sources moving at different speeds and/or in different directions, multiple signal sources being arranged at different positions, and/or multiple receiver antennas being arranged at different positions.

According to an aspect of the present invention, the signal generator system is configured to generate the at least two different modified waveform data streams independent of each other. Thus, different testing scenarios and/or different aspects of a testing scenario can be emulated independent of each other.

According to a further aspect of the present invention, the at least two different modified waveform data streams correspond to the same waveform data stream. Accordingly, different testing scenarios and/or different aspects of a testing scenario can be emulated based on the same waveform data stream. Thus, it is not necessary to provide different waveform data streams for each testing scenario or each aspect of a testing scenario, which significantly reduces the data bandwidth required by the signal generator system according to the present invention.

Another aspect of the present invention provides that the at least two different modified waveform data streams correspond to different waveform data streams. This allows to perform emulations of complex testing scenarios and/or seamless switching between different testing scenarios.

In an exemplary embodiment of the present invention, the at least one waveform data stream comprises a recorded waveform. Accordingly, the signal generator system according to the present invention adapts the previously recorded waveform in order to emulate certain different testing scenarios, instead of having to record appropriate waveforms for each different testing scenario.

For example, the waveform may be recorded using at least one RF antenna, particularly a plurality of RF antennas or an RF antenna array.

According to an aspect of the present invention, the at least one data input comprises at least one Ethernet port. Accordingly, the at least one waveform data stream may be transmitted, received and processed based on the Ethernet standard, which ensures reliable data transmission at high bandwidths. Moreover, as Ethernet is a common standard used in a multitude of different computer systems, this ensures maximum compatibility with different computer systems.

In fact, the at least one data input may be configured to receive the at least one waveform data stream via an Ethernet UDP stack. This allows for a particularly high data bandwidth with particularly low latency, thereby enabling fast and reliable transfer of large data volumes.

An aspect of the present invention provides that the at least one waveform data stream has a first bandwidth, wherein the at least one waveform processing circuit is configured to separate the at least one waveform data stream into a plurality of waveform data sub-streams, wherein each waveform data sub-stream has a bandwidth being a sub-band of the first bandwidth. Accordingly, the different sub-bands of the waveform data stream can be processed individually, which provides even more flexibility for emulating testing scenarios.

The individual waveform data sub-streams may be manipulated or rather modified in the same manner or in different manners.

Particularly, the individual waveform data sub-streams may be manipulated ore rather modified independent of each other.

For example, the different waveform data sub-streams may correspond to different aspects of a testing scenario, such as different signal sources and/or different receiver antennas being emulated.

In a further exemplary embodiment of the present invention, the at least one waveform processing circuit is configured to separate the at least one waveform data stream into a plurality of waveform data sub-streams, wherein the at least one waveform processing circuit is configured to generate a plurality of modified waveform data streams based on the plurality of waveform data sub-streams.

The RF frontend described above may be configured to generate a plurality of RF transmission signals based on the plurality of modified waveform data sub-streams.

The plurality of plurality of modified waveform data streams, and thus the plurality of RF transmission signals may correspond to different aspects of a testing scenario, such as different objects, an environment of the objects, different signal sources, different receiver antennas, atmospheric distortions, etc. Accordingly, a plurality of aspects of the testing scenario can be emulated simultaneously by the signal generator system according to the present invention.

Alternatively or additionally, the plurality of plurality of modified waveform data streams, and thus the plurality of RF transmission signals may correspond to different testing scenarios, which allows for a seamless switching between the different testing scenarios.

The signal generator system may comprise a plurality of RF outputs, wherein the signal generator system is configured to output a plurality of RF transmission signals corresponding to the plurality of modified waveform data streams via the plurality of RF outputs. In fact, the plurality of RF outputs may be part of the RF output interface described above.

Accordingly, the plurality of RF transmission signals may be transmitted over the air via the at least one RF antenna, e.g. to the device under test, such that the device under test can be tested over the air.

The at least one RF antenna may comprise a single RF antenna, a plurality of RF antennas, and/or an RF antenna array.

Alternatively, the device under test can be connected directly to one or several of the plurality of RF outputs, such that at least one of the plurality of RF transmission signals may be transmitted to the device under test via a wire-based connection, thereby enabling hardware-in-the-loop (HIL) testing of the device under test.

It is also conceivable that multiple devices under test may be connected to different RF outputs, such that simultaneous testing of multiple device under test is enabled.

The signal generator system may comprise a summation circuit, wherein the summation circuit is configured to sum at least two of the plurality of modified waveform data streams. Accordingly, the resulting summed modified waveform data stream may comprise different events or rather different aspects of a testing scenario, wherein the individual aspects may correspond to the individual modified waveform data streams before summation.

Particularly, the summation circuit may be configured to sum each modified waveform data stream of the plurality of modified waveform data streams.

In an exemplary embodiment of the present invention, the waveform data stream comprises at least one fading parameter. This enables particularly realistic emulation of testing scenarios.

According to an aspect of the present invention, the control command signal corresponds to a predefined test scenario for a device under test. Accordingly, the waveform data stream is adapted or rather modified to correctly emulate the predefined test scenario based on the control command signal.

In other words, the same waveform data stream can be adapted to emulate different test scenarios by providing the appropriate control command signal for the respective test scenario.

The control command signal has a substantially smaller data volume than the waveform data stream. Thus, different test scenarios can be emulated by the signal generator system according to the present invention with substantially less data bandwidth required.

In fact, the predefined test scenario may comprise at least one of a radar test, an angle of arrival system test, or a phased antenna array test. Thus, the signal generator system according to the present invention allows for testing a large variety of different devices under test.

In a further exemplary embodiment of the present invention, the control command signal comprises information on at least one of frequency changes to be applied to the at least one waveform data stream, amplitude changes to be applied to the at least one waveform data stream, or phase changes to be applied to the at least one waveform data stream. By applying these changes to the waveform data stream, test scenarios for testing a device under test can be emulated precisely

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a signal generator system according to the present invention;
- Figure 2 schematically shows a test and/or measurement instrument of the signal generator system of Figure 1;
- Figure 3 schematically shows a first variant of a waveform processing circuit of the test and/or measurement instrument of Figure 2;
- Figure 4 schematically shows a first exemplary variant of a portion of the test and/or measurement instrument of Figure 2; and
- Figure 5 schematically shows a second exemplary variant of a portion of the test and/or measurement instrument of Figure 2.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, or C", for example, means (A), (B), (C), (A and B), (A and C), (B and C), or (A, B, and C), including all further possible permutations when more than three elements are listed. In other words, the term "at least one of A or B" generally means "A and/or B", namely "A" alone, "B" alone or "A and B".

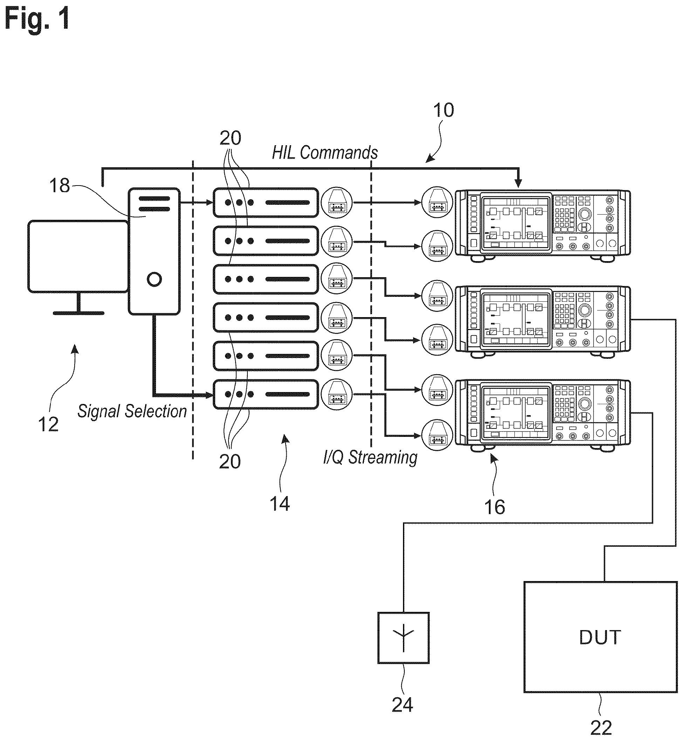

Figure 1 schematically shows a signal generator system 10 for generating a radio frequency, RF, signal.

The signal generator system 10 comprises at least one control circuit 12, a data storage 14, and at least one test and/or measurement instrument 16.

In the exemplary embodiment shown in Figure 1, the at least one control circuit 12 is implemented into a computer device 18. For example, the computer device 18 may be a personal computer, a MAC, a laptop, a notebook, a smartphone, or any other suitable type of smart device.

The data storage 14 may be established as a cloud storage that is established by a plurality of servers 20.

However, the data storage 14 may also be established as a local data storage, such as a hard drive or a plurality of hard drives.

In general, waveform data is stored in the data storage 14, which may correspond to a recorded waveform, particularly a plurality of recorded waveforms.

The waveform data may be saved as IQ-data, i.e. the waveform data may comprise in-phase data and quadrature data relating to the stored waveforms.

The at least one test and/or measurement instrument 16 may be established as at least one signal generator device, such as a signal generator, a vector signal generator, or an arbitrary waveform generator.

In general, the signal generator system 10 is configured to generate at least one RF transmission signal based on at least one waveform data stream in order to perform tests and/or measurements on a device under test (DUT) 22 corresponding to a predefined testing scenario.

More precisely, the at least one control circuit 12 selects the testing scenario for testing the device under test 22, and the corresponding waveform(s) being necessary for performing the corresponding tests.

For example, the control circuit 12 may select the testing scenario based on a user input received via a suitable user interface.

As another example, the control circuit 12 may select the testing scenario automatically, e.g. according to a testing routine for the device under test 22.

The testing scenario may comprise several aspects, such as different objects, an environment of the objects, different signal sources, movements of the objects, movements of the signal sources, different receiver antennas capturing a signal, atmospheric distortions, etc.

Moreover, the control circuit 12 determines which adjustments to the stored waveform(s) are necessary in order to perform the tests, and generates a corresponding control command signal that is forwarded to the at least one test and/or measurement instrument 16 ("HIL Commands" in Figure 1).

The at least one control circuit 12 controls the data storage 14 to stream the selected waveform(s) to the at least one test and/or measurement instrument 16, namely as at least one waveform data stream being an IQ-data stream.

The at least one test and/or measurement instrument 16 is configured to receive the at least one waveform data stream from the data storage 14.

The test and/or measurement instrument 16 further is configured to generate at least one RF transmission signal that is to be applied to the device under test 22 based on the at least one waveform data stream received and based on the control command signal received, as will be described in more detail below.

As is schematically illustrated in Figure 1, the device under test 22 may be connected to the at least one test and/or measurement instrument 16 via a wire-based connection. Accordingly, the at least one RF transmission signal may be applied to the device under test 22 via the wire-based connection.

Alternatively or additionally, the signal generator system 10 may comprise at least one RF antenna 24 that is connected the at least one test and/or measurement instrument 16 and that allows for testing the device under test 22 over the air.

The at least one RF antenna 24 may be a single RF antenna, a plurality of RF antennas, or an RF antenna array.

In fact, the at least one RF antenna 24 may be part of a test setup that may comprise other equipment such as an anechoic chamber, a variable holder for the device under test 22, reflectors, absorbers, etc.

In general, the at least one waveform selected by the at least one control circuit depends on the type of the device under test 22, i.e. different waveforms may be selected for testing different types of devices under test.

The device under test 22 may be, for example, a radar device, a direction finding device, a phased antenna array, or an angle of arrival system, particularly an angle of arrival system for a Traffic Alert and Collision Avoidance System (TCAS).

However, it is to be understood that the device under test 22 may be any type of device that can be tested by applying an RF signal.

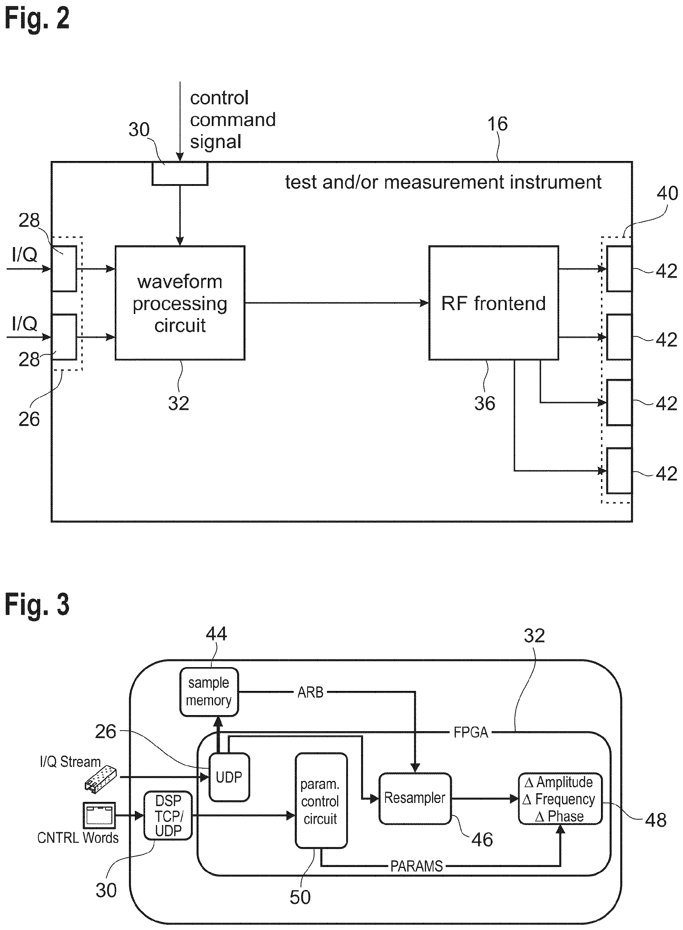

Figure 2 schematically shows one of the test and/or measurement instruments 16 in more detail.

The test and/or measurement instrument 16 comprises a data input interface 26 that has at least one data input 28 being configured to receive the at least one waveform data stream from the data storage 14.

Therein, the data input interface 26 is connected to the data storage 14, for example via the Internet, via a wide area network, or via a local area network.

In the exemplary embodiment shown in Figure 2, the data input interface 26 comprises two data inputs 28.

However, it is to be understood that the data input interface 26 may comprise any other number of data inputs 28, such as one, four, six, eight, etc.

For example, the data inputs 28 may be established as an Ethernet port, respectively.

In fact, the data input interface 26 may be established as a Quad Small Form-factor Pluggable (QSFP) interface.

The test and/or measurement instrument 16 further comprises at least one control input 30 that is connected to the at least one control circuit 12.

The at least one control input 30 is configured to receive the control command signal from the at least one control circuit 12.

The at least one control input 30 may be established as any suitable type of input, for example as an Ethernet port.

The test and/or measurement instrument 16 further comprises a waveform processing circuit 32 that is connected to both the data input interface 26 and the control input 30 so as to receive the at least one waveform data stream.

In general, the waveform processing circuit 32 is configured to modify the at least one waveform data stream based on the control command signal, thereby obtaining at least one modified waveform data stream.

As already mentioned above, the at least one waveform data stream comprises IQ-data relating to at least one waveform to be generated.

Accordingly, the at least one modified waveform data stream comprises modified IQ-data that describes the at least one waveform to be generated, but adapted according to the predefined testing scenario.

For example, an amplitude, a phase, and/or a frequency of waveform represented by the IQ-data may be adapted to obtain the modified IQ-data.

With these modifications, different aspects of the testing scenario can be emulated correctly, such as Doppler effect, fading, multi-propagation of signals, external distortions, multiple signal sources, multiple receivers, etc.

For example, the waveform processing circuit 32 may be implemented on an FPGA.

Moreover, the test and/or measurement instrument 16 comprises an RF frontend 36 that is arranged downstream of the waveform processing circuit 32.

In general, the RF frontend 36 is configured to generate at least one RF transmission signal based on the at least one modified waveform data stream.

Therein, the RF frontend 36 may be configured to up-convert a frequency of the at least one modified waveform data stream to a frequency being suitable for performing tests on the device under test 22, thereby obtaining the at least one RF transmission signal. Any suitable type of RF frontend known in the state of the art may be used.

The RF frontend 36 may comprise at least one digital-to-analog converter being configured to convert the at least one modified waveform data stream into an analog signal.

The test and/or measurement instrument 16 further comprises an RF output interface 40 that comprises at least one RF output 42.

The RF output interface 40 is connected to the RF frontend 36, such that the at least one RF transmission signal is forwarded to the at least one RF output 42.

In the exemplary embodiment shown in Figure 2, the RF output interface 40 comprises a plurality of RF outputs 42.

However, it is to be understood that the RF output interface 40 may comprises an arbitrary number of RF outputs 42.

The RF frontend 36 may be configured to selectively forward the at least one up-converted RF transmission signal to the plurality of RF outputs 42.

The RF output interface 40, or more precisely the individual RF outputs 42, may be connected to the device under test 22 and/or to the at least one RF antenna 24, such that the at least one RF transmission signal is forwarded to the device under test 22 and/or to the at least one RF antenna 24.

Figure 3 shows a portion of the test and/or measurement instrument 16 comprising the waveform processing circuit 32 in more detail.

As is shown in Figure 3, the test and/or measurement instrument 16 may further comprise a sample memory 44 that is connected to the data input interface 26.

The sample memory 44 is configured to store the at least one waveform data stream received via the data input interface 26 at least temporarily.

The sample memory 44 may be a non-transient memory.

As another example, the sample memory 44 may be a temporary memory such as a random access memory.

The waveform processing circuit 32 comprises a resampling circuit 46, a modification circuit 48, and a parameter control circuit 50.

In the exemplary embodiment shown in Figure 3, the resampling circuit 46 is connected to both the data input interface 26, and to the sample memory 44.

The at least one waveform data stream received by the data input interface 26 may comprise information on the sample rate of the at least one waveform data stream.

The information on the sample rate may be transmitted from the data input interface 26 to the resampling circuit 46.

The resampling circuit 46 may receive the at least one waveform data stream from the sample memory 44.

The resampling circuit 46 is configured to adapt a sample rate of the at least one waveform data stream by resampling the at least one waveform data stream, wherein the sample rate may be increased or decreased.

Particularly, the resampling circuit 46 may be configured to resample the at least one waveform data stream based on the information on the sample rate received from the data input interface 26.

Alternatively or additionally, the resampling circuit 46 may be configured to resample the at least one waveform data stream based on a target sample rate needed by the at least one digital-to-analog-converter of the RF frontend 36, such that the resampled at least one waveform data stream has the target sample rate.

In fact, a resampling factor applied by the resampling circuit 46 may b configured based on the information on the sample rate received from the data input interface 26, and based on the target sample rate.

The resampled at least one waveform data stream is forwarded to the modification circuit 48.

The parameter control circuit 50 is connected to the control input 30 so as to receive the control command signal.

In general, the control command signal comprises information on the modifications to the applied to the at least one waveform data stream in order to correctly emulate the testing scenario selected by the control circuit 12.

For example, the control command signal may comprise control words indicating the modifications to be applied to the at least one waveform data stream.

Based on the control command signal, the parameter control circuit 50 generates a parameter control signal that comprises information on how signal parameters need to be adapted.

The signal parameters to be adapted may comprise an amplitude, a phase, and/or a frequency.

The parameter control signal is forwarded to the modification circuit 48.

The modification circuit 48 is configured to modify the resampled at least one waveform data stream based on the parameter control signal, thereby obtaining the at least one modified waveform data stream.

More precisely, the modification circuit 48 may adapt the amplitude, phase, and/or frequency of the resampled at least one waveform data stream based on the parameter control signal.

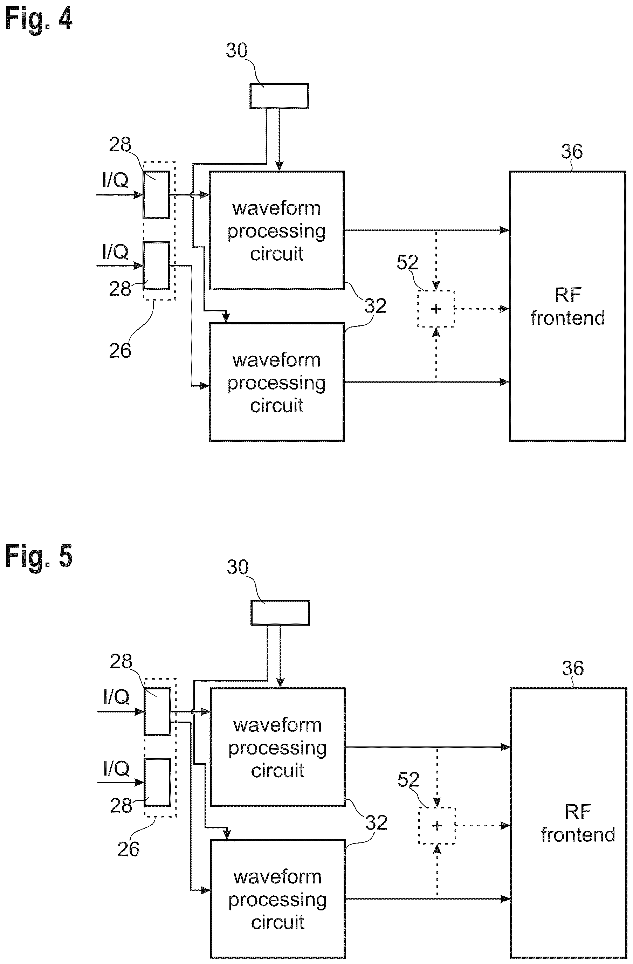

It is noted that, as is illustrated in Figure 4, the test and/or measurement instrument 16 may comprise a plurality of waveform processing circuits 32 processing a plurality of waveform data streams in parallel, such that a plurality of modified waveform data streams are obtained.

Therein, different waveform data streams may be modified based on the same control command signal, or independent of each other based on different control command signals.

The different modified waveform data streams may be output individually or may, alternatively or additionally, be summed by a summation circuit 52.

According to a further variant shown in Figure 5, a single waveform data stream may be separated into a plurality of waveform data subs-streams.

Therein, each waveform data sub-stream may have a bandwidth being a sub-band of the bandwidth of the original waveform data stream.

The different waveform data sub-streams may be modified based on the same control command signal, or independent of each other based on different control command signals, thereby obtaining a plurality of modified waveform data sub-streams.

The different modified waveform data streams may be output individually or may, alternatively or additionally, be summed by the summation circuit 52.

It is noted that, of course, an analysis of an output signal generated by the device under test 22 in response to the at least one RF transmission signal applied to the device under test 22 may be performed in order to analyze a performance of the device under test 22, namely by a corresponding analysis circuit and/or a corresponding measurement instrument, particularly by one of the test and/or measurement instruments 16.

However, the corresponding analysis circuits are not shown in the Figures in order to enhance the visual clarity of the signal chain generating the RF transmission signal(s).

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A signal generator system for generating a radio frequency, RF, signal,
wherein the signal generator system (10) comprises at least one data input (28), at least one control input (30), and a waveform processing circuit (32),
wherein the at least one data input (28) is configured to receive at least one waveform data stream, the at least one waveform data stream comprising information on a waveform to be generated,
wherein the at least one control input (30) is configured to receive at least one control command signal, the control command signal comprising control information for modifying the data stream,
wherein the at least one waveform processing circuit (32) is configured to modify the at least one waveform data stream based on the control command signal, thereby obtaining at least one modified waveform data stream.

2. The signal generator system of claim 1, wherein the waveform data stream is an IQ-data stream.

3. The signal generator system according to any one of the preceding claims, wherein the signal generator system (10) comprises at least one RF frontend (36), wherein the at least one RF frontend (36) is configured to generate at least one RF transmission signal based on the at least one modified waveform data stream, particularly wherein the signal generator system (10) further comprises an RF output interface (40), wherein the RF output interface (409 is connectable to at least one RF antenna (24) and/or to a device under test (22).

4. The signal generator system according to any one of the preceding claims, further comprising at least one sample memory (44) being connected to the at least one data input (28), wherein the at least one sample memory (44) is configured to store the waveform data stream received via the data input (28).

5. The signal generator system according to any one of the preceding claims, wherein the signal generator system (10) is configured to generate at least two different modified waveform data streams, particularly wherein the signal generator system (10) is configured to generate the at least two different modified waveform data streams independent of each other.

6. The signal generator system of claim 5, wherein the at least two different modified waveform data streams correspond to the same waveform data stream.

7. The signal generator system of claim 5, wherein the at least two different modified waveform data streams correspond to different waveform data streams.

8. The signal generator system according to any one of the preceding claims, wherein the at least one waveform data stream comprises a recorded waveform.

9. The signal generator system according to any one of the preceding claims, wherein the at least one data input (28) comprises at least one Ethernet port, particularly wherein the at least one data input (28) is configured to receive the at least one waveform data stream via an Ethernet UDP stack.

10. The signal generator system according to any one of the preceding claims, wherein the at least one waveform data stream has a first bandwidth, wherein the at least one waveform processing circuit (32) is configured to separate the at least one waveform data stream into a plurality of waveform data sub-streams, wherein each waveform data sub-stream has a bandwidth being a sub-band of the first bandwidth.

11. The signal generator system according to any one of the preceding claims, wherein the at least one waveform processing circuit (32) is configured to separate the at least one waveform data stream into a plurality of waveform data sub-streams, wherein the at least one waveform processing circuit (32) is configured to generate a plurality of modified waveform data streams based on the plurality of waveform data sub-streams.

12. The signal generator system of claim 11, comprising a plurality of RF outputs (42), wherein the signal generator system (10) is configured to output a plurality of RF transmission signals corresponding to the plurality of modified waveform data streams via the plurality of RF outputs (42).

13. The signal generator system of claim 11, further comprising a summation circuit (52), wherein the summation circuit (52) is configured to sum at least two of the plurality of modified waveform data streams.

14. The signal generator system according to any one of the preceding claims, wherein the waveform data stream comprises at least one fading parameter.

15. The signal generator system according to any one of the preceding claims, wherein the control command signal corresponds to a predefined test scenario for a device under test (22), particularly wherein the predefined test scenario comprises at least one of a radar test, an angle of arrival system test, or a phased antenna array test.

16. The signal generator system according to any one of the preceding claims, wherein the control command signal comprises information on at least one of frequency changes to be applied to the at least one waveform data stream, amplitude changes to be applied to the at least one waveform data stream, or phase changes to be applied to the at least one waveform data stream.
